# FASCICULE DE BREVET EUROPEEN

(11) **EP 0 770 006 B1**
(45) Date de publication et mention de la délivrance du brevet: **07.01.1998**
(21) Numéro de dépôt: 95925010.1
(22) Date de dépôt: 05.07.1995
(51) Int. Cl.: B41N 1/24, B41F 15/36, B41C 1/14

(54) **POCHOIR POUR LE DEPOT ET LE DOSAGE DE COUCHES PLUS OU MOINS EPAISSES, A BASE DE POINTS, D'UN PRODUIT VISQUEUX**
PERFORIERTE SIEBDRUCKSCHABLONE ZUM AUFBRINGEN UND DOSIEREN VON MEHR ODER WENIGER DICKEN SCHICHTEN EINES VISKOSEN PRODUKTES
STENCIL FOR DEPOSITING AND PORTIONING VARIOUSLY THICK SPOT LAYERS OF A VISCOUS MATERIAL

(30) Priorité: 07.07.1994 FR 9408518
(43) Date de publication de la demande: 02.05.1997
(73) Titulaire: Bourrieres, Francis, F-82000 Montauban (FR)
(72) Inventeur: Bourrieres, Francis, F-82000 Montauban (FR)
(74) Mandataire: Ravina, Bernard
(86) Numéro de dépôt international: FR9500898
(87) Numéro de publication internationale: WO9601743

(56) Documents cités:
- EP-A- 0 529 632
- EP-A- 0 593 050
- EP-A- 0 622 247
- GB-A- 2 054 462
- US-A- 3 981 237

## Description

La présente invention concerne un pochoir pour le dépôt et le dosage de couches plus ou moins épaisses, à base de points, d'un produit visqueux.

La présente invention se situe dans les technologies de montage en surface de composants électroniques sur des circuits imprimés et en micro-électronique.

En fabrication électronique, les dépôts de couches dites épaisses, crèmes à braser et colle notamment, se font soit à la seringue, soit par sérigraphie. Le dépôt par seringue est un procédé hasardeux et d'une productivité limitée. La précision de son tracé, la durée de sa mise en oeuvre, et la finesse des traits et des réseaux constitués, écartent ce premier moyen des applications industrielles actuelles.

Bien que la pâte ou la colle puisse ainsi être déposée par des équipements de distribution de liquides, la méthode préférée est la sérigraphie à travers écran, utilisant un écran ou pochoir métallique fabriqué par découpe chimique, par découpe au laser ou par électroformage. Ces trois méthodes sont valables pour des dimensions allant jusqu'à 300 micro-mètres mais des dimensions encore plus petites sont nécessaires.

L'utilisation d'un pochoir à travers lequel est déposé un produit, la crème ou pâte à braser qui forme ensuite les plots de contact souhaités, est le procédé le plus utilisé industriellement.

Trois types de pochoirs sont connus à ce jour : la toile tissée métallique de sérigraphie, la toile tissée en polyester de sérigraphie et le pochoir métallique. Leurs qualités techniques s'apprécient selon leur rendement ou pourcentage d'ouverture, le hors-contact, la force de tension appliquée.

Le rendement correspond au degré d'obturation des orifices du pochoir qui est fonction de la présence de fils dans le cas de pochoir tissé.

Le hors contact est l'angle pouvant être formé par le pochoir avec la surface support en position de travail lorsque la racle est en appui.
Plus cet angle est important, meilleur est l'arrachement du produit visqueux du pochoir.
L'obtention du hors contact suppose une force de tension importante du pochoir et un bon coefficient de déformation élastique.
Selon le hors-contact, la toile de sérigraphie métallique est moins bonne que la toile de sérigraphie en polyester et meilleure qu'un pochoir métallique.

Pour le rendement et la force de tension, la toile de sérigraphie en polyester est moins bonne que la toile de sérigraphie métallique qui est elle-même moins bonne que le pochoir métallique.
La méthode et les moyens d'usinage des pochoirs conditionnent également la qualité des dépôts ainsi qu'il sera expliqué plus loin.

La présente invention remédie à ces inconvénients en présentant un moyen de dépôt de couches épaisses par utilisation d'un pochoir réalisé par une feuille pleine et homogène en matière synthétique souple et extensible percée par des moyens de découpe en conformité avec les dépôts à réaliser.
De tels pochoirs ont été utilisés.

Le brevet GB 2054462 utilise un tel pochoir pour masquer du métal en vue d'une gravure électrochimique donc d'un enlèvement de métal en non d'un dépôt de produit visqueux. La notion d'épaisseur du pochoir et de hauteur variable des dépôts est étrangère à ce brevet.

Le brevet US 3 981 237 utilise un tel pochoir pour l'impression d'encre sur des textiles, le pochoir ou masque étant monté sur un tambour rotatif. L'objet est différent dans la présente invention, qui vise à déposer et à doser des produits visqueux.

L'invention se caractérise essentiellement en ce que le pochoir pour le dépôt et le dosage de couches plus ou moins épaisses à base de points ou en forme de points d'un produit visqueux sur un substrat, ledit pochoir étant constitué d'une feuille pleine et homogène en un matériau synthétique dotée d'orifices réalisés par des perçages. L'épaisseur de la feuille est déterminée en fonction de la plus grande hauteur de dépôt à réaliser sur le substrat, et que la feuille présente des diamètres de perçage différents en fonction de la hauteur des différents dépôts à réaliser, les dits diamètres étant également conditionnés par l'épaisseur de la feuille, les dits perçages constituant réservoir chargés à chaque passage d'une racle d'une quantité de produits dont tout ou partie sera déposée sur le substrat de manière régulière par contact étroit entre le pochoir et le substrat à l'endroit où la racle exerce une pression linéaire et en regard de l'ouverture des perçages, ce qui permet de doser les quantités de produit déposées et de contrôler la hauteur des dépôts, les doses de produit déposées et les hauteurs de dépôt obtenues par un seul passage de la racle étant différentes.

L'épaisseur de la feuille du pochoir est déterminée en fonction de la plus grande hauteur de dépôt à réaliser, et présente des perçages de diamètre différents selon les doses de produit à apposer sur le substrat et les hauteurs de dépôt, le plus petit diamètre pouvant aller jusqu'à être de dimension inférieure à l'épaisseur de la feuille du pochoir.

Pour remédier aux problèmes rencontrés sur l'écran sérigraphique en toile polyester ou métallique et au pochoir métallique, la présente invention propose d'utiliser une toile en polyester ou analogue, cette toile n'est plus constituée de fils mais est, elle même, une feuille pleine. Cette feuille pleine en polyester est percée mécaniquement aux endroits voulus. La toile polyester, du fait qu'elle est pleine, admet des forces de tension supérieure aux toiles à fils métalliques et au moins égale aux pochoirs métalliques.

La description qui va suivre, faite en regard des dessins annexés dans un but explicatif et nullement limitatif permet de mieux comprendre les avantages, buts et caractéristiques de la présente invention.

La figure 1 présente les textures de masques et pochoirs de types connus.

La figure 2 présente des coupes de pochoirs et leurs qualités respectives.

La figure 3 présente une vue d'un dépôt de couche épaisse en cours.

La figure 4 présente deux pochoirs, l'un étant réalisé selon la présente invention et l'autre étant représentatif de l'état de l'art antérieur.

La figure 5 représente une vue en coupe d'un pochoir selon l'invention sur la plaque de circuits imprimés qui doit recevoir les dépôts.

La figure 6 représente un exemple vu en plan et en coupe de dépôt simultané de points de colle de hauteur et diamètre différents en fonction du type de composant.

La figure 7 représente vu en plan un exemple de constitution avec l'invention de barrières physiques entre des zones où il existe un risque de pont lors du passage de la vague de soudage des composants.

La figure 8 représente des exemples de réalisation, par mise en oeuvre de l'invention, de traits continus ou de surfaces pleines.

La figure 9 représente le pochoir schématiquement en fonctionnement dans différents cas de figures.

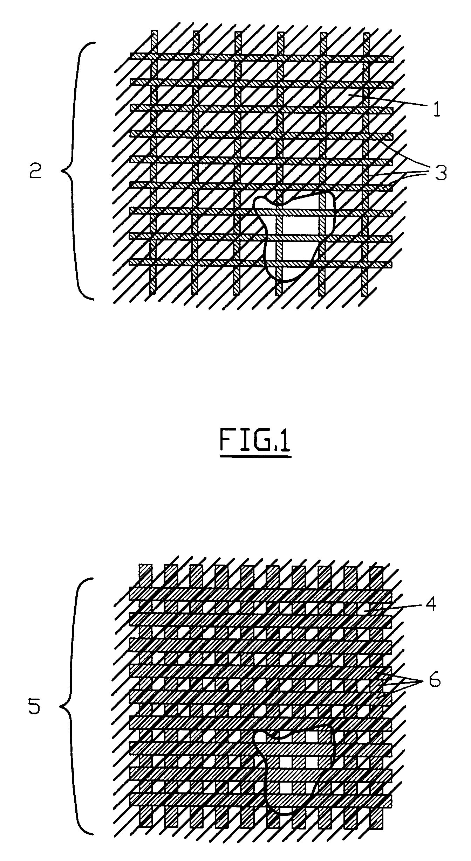

Dans la figure 1 sont présentés les textures de masques et pochoirs de types connus.

On trouve dans la figure 1, une maille 1 d'un réseau 2 faite dans un tissu de fils métalliques inoxydables 3, une maille 4 d'un réseau 5 faite dans un tissu de fils polyester 6.

Les mailles 1 et 4 ont des surfaces identiques. Cependant, le rendement du réseau 2 est supérieur à celui du réseau 5 puisque les diamètres des fils 3 sont inférieurs aux diamètres des fils 6. La valeur de tension est identique pour les réseaux 2 et 5. Enfin le hors contact est meilleur pour le réseau 5 que pour le réseau 2.

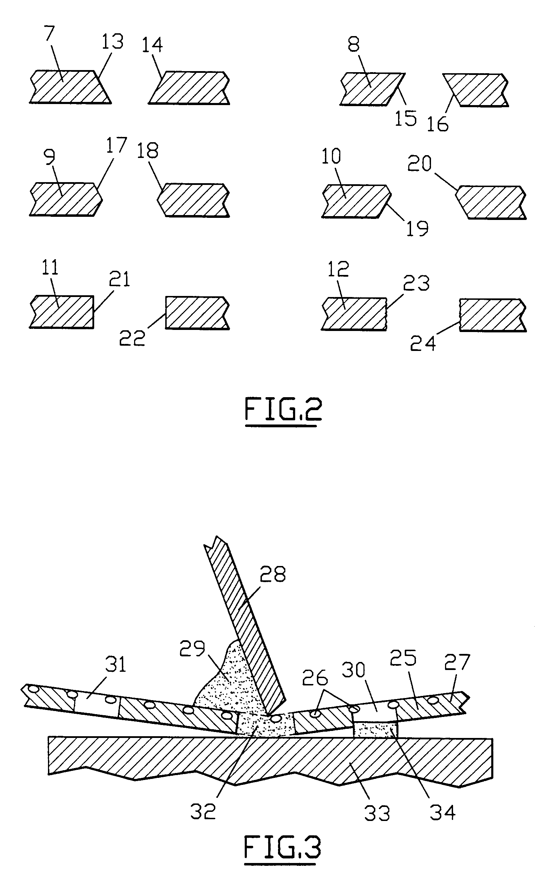

La figure 2 présente des coupes de pochoirs et leurs qualités respectives.

Dans la figure 2 sont représentées des coupes d'écrans de sérigraphies 7, 8, 9, 10, 11 et 12, passant chacune par une ouverture dont les flancs 13 et 14 pour l'écran 7, 15 et 16 pour l'écran 8, 17 et 18 pour l'écran 9, 19 et 20 pour l'écran 10, 21 et 22 pour l'écran 11, 23 et 24 pour l'écran 12, possèdent des formes différentes.

Ces formes correspondent à des qualités de sérigraphie différentes.

Les écrans sont considérés comme étant constitués de la même matière et utilisés par remplissage par le haut et dépôt par le bas, comme présenté en figure 3.

Les flancs 13 et 14 correspondent à un bon remplissage puisque les flancs 13 et 14 sont plus proches entre eux en bas qu'en haut.

Les flancs 15 et 16 correspondent à un bon démoulage puisque les flancs 15 et 16 sont plus proches entre eux, en haut qu'en bas.

Les flancs 17 et 18 correspondent à un compromis usuel entre ces deux formes et ces deux qualités. Les flancs sont rapprochés entre eux à égale distance des deux surfaces de l'écran 9.

Les flancs 19 et 20 correspondent à un compromis favorisant le démoulage puis-qu'ils sont plus rapprochés entre eux à une distance plus faible de la surface supérieure que de la surface inférieure de l'écran 10.

Les quatre formes présentées ci-dessus correspondent à la réalisation chimique des découpes.

Les flancs 21 et 22 correspondent à une forme idéale. Ils sont parallèles entre eux et perpendiculaires à l'écran 11.

Les flancs 23 et 24 correspondent à la forme obtenue par découpage laser. Leurs formes sont très proches de celles des flancs 21 et 22, cependant ils sont rugueux.

La sérigraphie utilise comme support, une toile en métal ou en polyester. Un masque réalisé à l'aide d'un film photosensible aux ultraviolets, permet la réalisation de pochoirs. La toile en polyester permet une certaine élasticité, ce qui autorise un hors-contact pouvant aller jusqu'à 3 ou 4 millimètres sans déformation de l'image. Le hors contact favorise le démoulage car il diminue les surfaces latérales en contact.

Ce hors-contact est très important car c'est lui qui permet l'arrachement de la matière à déposer, du trou de la toile, non obstrué lors du passage de la racle. Plus la force de tension de la toile est grande, meilleur est l'arrachement de la toile et meilleur est le dépôt.

Dans le cas d'une toile polyester, la tension peut être d'autant plus importante que le nombre de fils par unité de longueur sera important. Or un nombre de fils plus important permet un rendement moindre (le rendement étant le rapport entre la surface libre et la surface totale de la maille).

Le pourcentage d'ouverture étant moindre, le passage du produit pâteux et/ou visqueux sera d'autant plus difficile et deviendra impossible pour de petites tailles d'ouverture.

La toile métallique, généralement en maille d'acier inoxydable, permet, du fait de sa résistance supérieure, d'offrir un pourcentage d'ouverture supérieur au polyester (70% maximum). De ce fait, la taille des dépôts pourra être réduite. Par contre le hors-contact possible sera inférieur au polyester et l'arrachement pourra être plus délicat, ce qui risque d'entraîner le produit dans l'écran (nota : la forte tension est proche de la limite de rupture).

Lorsque la taille des dépôts exigés doit être encore plus le recours à un pochoir métallique s'impose. Dans ce cas, le pourcentage d'ouverture est de 100 %. Or le défaut majeur du pochoir métallique est de n'admettre pratiquement aucun hors-contact. Le métal n'est pas extensible, il est rigide et son angle de pliage admissible est très faible.

Dans la pratique, un pseudo hors contact est obtenu en suspendant le pochoir métallique sur un tamis en fils de polyester.
Avec le métal, la zone de contact est très large.
Avec le matériau synthetique, en feuille selon l'invention, qui est souple et extensible, l'angle admissible de pliage étant très grand, une surface de contact de faible largeur est obtenue.
Ceci est un problème majeur car il arrive souvent, pour les petites ouvertures, que les forces d'adhérence du produit à déposer sur la surface latérale du trou soient supérieures aux forces d'adhérence du produit sur le support. Dans ce cas, le dépôt ne peut pas se faire et le produit est entraîné sur le pochoir.

La figure 3 présente une vue d'un dépôt de couche épaisse en cours.

Dans la figure 3 sont représentés un pochoir 25 comportant des fils 26 et une matière 27, sur lequel s'appuie une racle 28 qui pousse une pâte à braser 29 ou colle ou toute autre matière visqueuse dans des orifices 30, 31 et 32, la pâte à braser ressortant des orifices et se déposant sous forme de points 34 sur un circuit imprimé 33 lorsque le pochoir 25 s'éloigne d'un circuit imprimé 33.

Le pochoir 25 est réalisé selon des procédés connus de l'homme de l'art. Il comporte des fils 26 qui assurent la solidité et une matière 27 qui assure l'étanchéité du pochoir 25. La racle 28 est de type connu. Elle est de dureté adaptée pour empêcher le passage de pâte entre elle et le pochoir 25. La pâte à braser 29 est une pâte visqueuse comportant différents composants dont des matériaux conducteurs de l'électricité. Elle se répand dans les orifices 30, 31 et 32. Dans la figure 3, l'orifice 31 est beaucoup plus petit que l'orifice 30. L'orifice 30 est vide et l'orifice 32 est en cours de remplissage.

Le pochoir est tendu vers le haut pour être éloigné du circuit imprimé 33 avant et après le passage de la racle 28. Elle-même appuie à la fois, la pâte à braser 29 sur le pochoir 25 et le pochoir 25 sur le circuit imprimé 33.

Lorsque la racle se déplace de la droite de la figure 3 vers la gauche, la pâte à braser entre dans les orifices 30, 32 puis 31 et ressort de ces orifices lorsque le pochoir s'éloigne du circuit imprimé 33. La pâte à braser 29 constitue alors des points 34 sur le circuit imprimé 33.

On comprend facilement sur cette figure pourquoi la forme des flancs des orifices 30, 31 et 32 réalisés dans le pochoir 25 correspondent aux qualités présentées en figure 2.

On comprend aussi que les qualités du pochoir 25 dépendent des fils 26 éventuellement insérés dans la matière 27, de l'élasticité du pochoir 25, de son épaisseur et de la manière de réaliser ses orifices.

Selon la présente invention, le pochoir ou écran de sérigraphie 25 est constitué d'une feuille pleine en un matériau synthétique extensible et souple tel que du polyester ou des dérivés plastiques ou des matériaux analogues, usinée préférentiellement par découpe mécanique pour réaliser les orifices circulaires.

Selon l'invention la matière utilisée pour la réalisation du pochoir est apte a subir une mise en forme localisée par déformation plastique par exemple pour permettre le passage de surépaisseurs.

La présente invention concerne ainsi aussi bien le pochoir 25, en tant que dispositif, que le procédé destiné à le réaliser.

Pour remédier aux problèmes rencontrés sur l'écran sérigraphique en toile polyester ou métallique et au pochoir métallique, la présente invention propose d'utiliser un écran de sérigraphie en polyester ou dérivés en une feuille pleine. Cette feuille pleine en polyester est percée mécaniquement ou thermiquement aux endroits voulus. La toile polyester, du fait qu'elle est pleine, admet des forces de tension supérieure aux toiles à fils métalliques et aux moins égales aux pochoirs métalliques.

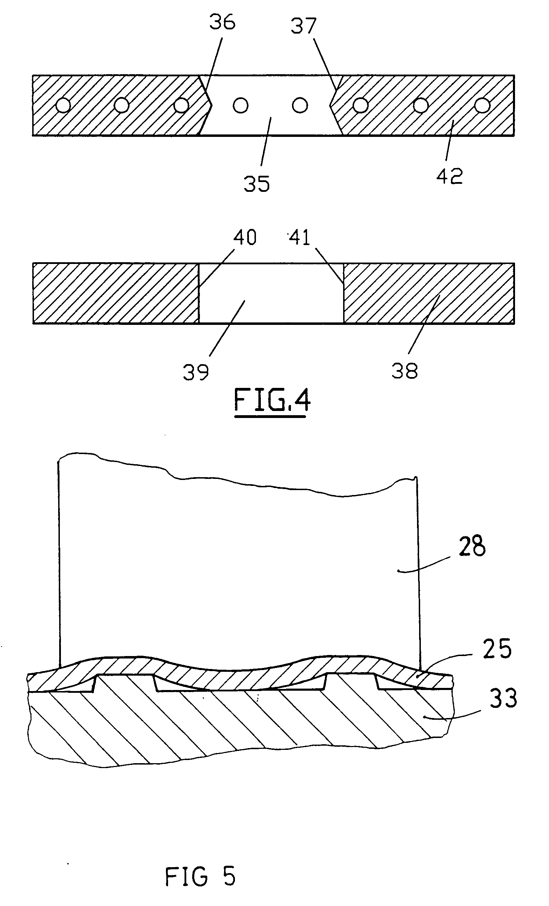

Dans la figure 4 sont représentés un pochoir 42 comportant un orifice 35 dont les flancs 36 et 37 sont un compromis classique dans l'industrie électronique et un pochoir 38 selon l'invention comportant un orifice 39 dont les flancs 40 et 41 sont réalisés par moyens mécaniques.

Le pochoir 42 est métallique. Il comporte un orifice 35 dont les flancs 36 et 37 ont été présentés en figure 2 comme le compromis habituel dans l'industrie électronique. Le pochoir 42 accepte mal les hors contact, possède un angle de pliage très limité à cause de son matériau de base, et possède des coefficients de frottement élevés.

Le pochoir 38 conforme à l'invention, est constitué d'une feuille pleine en polyester usinée par découpage mécanique. Il comporte un orifice 39 dont les flancs 40 et 41 sont réalisés par perçage et possèdent donc une forme presque idéale, comme présenté en figure 2.

Le pochoir 38 accepte des hors-contacts élevés, possède un angle de pliage très élevé et un coefficient de frottement faible. La précision de la forme de découpe est très élevée.

La figure 5 présente un pochoir réalisé selon la présente invention.

En figure 5, est représentée la réalisation d'un dépôt sur une surface de substrat 33 à travers un pochoir selon l'invention 25 au moyen d'une racle 28.

Le circuit imprimé qui va recevoir les dépôts de produits visqueux ou pâteux et/ou collants présente un relief ou des aspérités d'épaisseurs variables. Ces reliefs sont dus à la présence de pistes et de plages d'accueil.

La règle à respecter pour qu'il y ait transfert du produit à déposer sur le substrat est qu'il y ait contact entre le pochoir et le substrat à l'endroit précis où la racle exerce une pression linéaire et en regard d'une ouverture.
S'il n'y a pas contact en regard de l'ouverture, le produit sera guidé par le trou mais sera reçu de manière aléatoire avec des étalements et des bavures.

Dans le cas de l'utilisation d'un pochoir en feuille selon l'invention (figure 5), les critères de souplesse et d'extensibilité du pochoir associés aux faibles valeurs du rayon de pliage admissible, entraînent une déformation du pochoir lui permettant d'entrer en contact avec le substrat y compris sur les points les plus bas.

Différents procédés d'usinages peuvent être prévus ; cependant, il est apparu que le perçage d'orifices circulaires était le plus adapté au pochoir polyester en feuille selon l'invention.

Si les paramètres de coupe sont bien adaptés, l'arête est franche et nette avec des possibilités de diamètres de perçage pouvant aller jusqu'à 0,1 mm.

Le grand avantage de l'usinage mécanique par forets réside dans le fait que pour un même diamètre de perçage, c'est le même foret qui opère quel que soit le nombre de trous ou orifices du diamètre concerné à réaliser.
Le foret est un outil à diamètre et à profil constant avec une vitesse de coupe calculée constante, il usine une matière d'épaisseur et de nature constante. Cela conduit à des diamètres de trous constants avec un état de surface identique sur tous les trous de même diamètre, les trous sont lisses avec une rugosité de l'ordre de 0,001 micron (pour 0,1 micron par une découpe laser).

La constance de ces paramètres appliqués au pochoir en feuille selon l'invention ainsi que le fait que les orifices réalisés pour un même diamètre sont rigoureusement identiques, permet de réaliser des dépôts rigoureusement semblables.

La modification de l'état de surface des perçages permet d'obtenir des résultats différents notamment sur le dosage des produits déposés, et la hauteur des points réalisés en relation avec le diamètre des perçages.

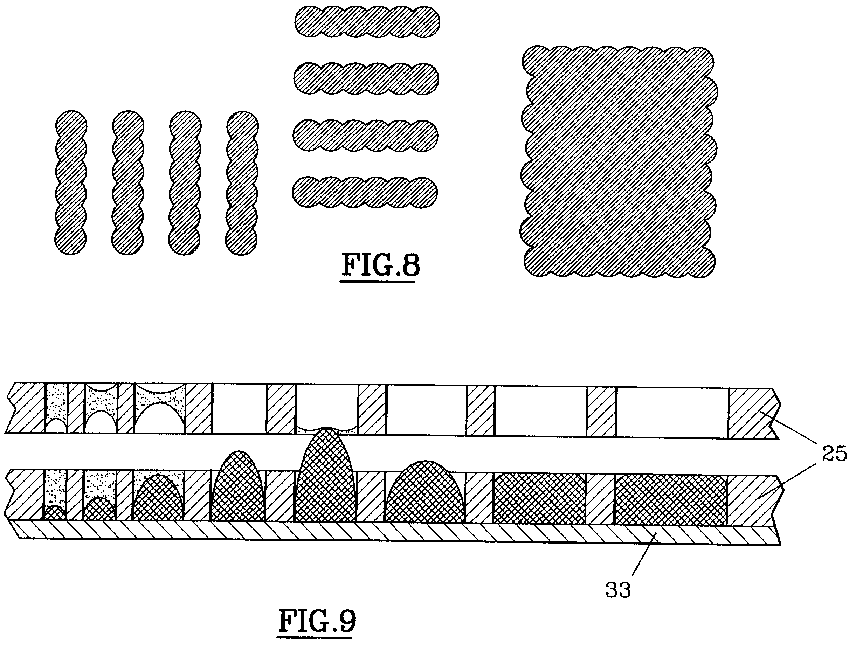

Dans cette figure 9, pour faciliter sa compréhension, le pochoir 25 a été représenté, d'une part appliqué sur le substrat 33 (circuit imprimé) et d'autre part, en cours de relevage pour représenter l'enlèvement de colle par le pochoir et l'action qu'il peut avoir sur la formation des points de colle.

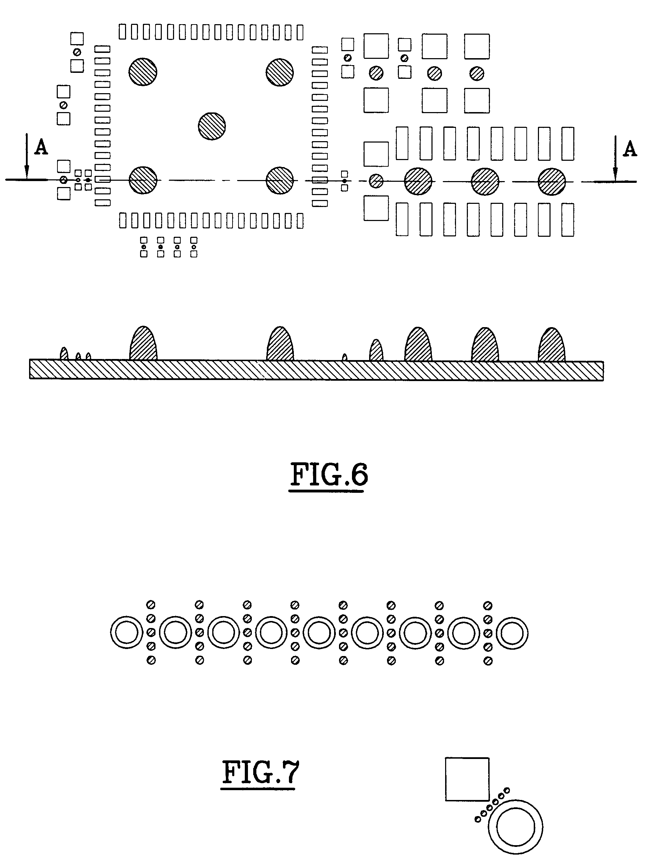

En figure 6 est représenté vu en plan et en coupe, un exemple de dépôt de points de colle de hauteurs différentes pour fixer des composants différents sur le circuit.

En figure 7 est représenté un exemple de constitution de barrières physiques par des points de colle entre des zones où existe un risque de pont lors du passage à la vague de soudage.

En figure 8 est représentée la réalisation par points de traits continus et de surfaces pleines.

La matière restant accrochée aux parois latérales des orifices de même diamètre est rigoureusement identique de l'un à l'autre.

La feuille pleine de polyester ne comporte aucun insert, ni aucune forme particulière. Son épaisseur est constante et elle est homogène.

De plus, le polyester utilisé est transparent, le repérage des positions respectives du pochoir et du circuit imprimé est donc meilleur.

La hauteur déposée est fonction du diamètre du trou, de la viscosité du produit, de sa densité, de l'épaisseur du pochoir et des forces qui s'opposent à l'écoulement (rugosité). Dans le cas du polyester, la rugosité étant constante, les autres paramètres étant constants, le résultat est constant, c'est à dire que pour un même diamètre de trou, nous avons toujours la même hauteur de dépôt. Avec un pochoir métal, la rugosité étant variable, les dépôts sont inconstants.
La viscosité est le facteur le plus influent sur la hauteur du dépôt, plus la viscosité est faible, plus la hauteur déposée se rapprochera de l'épaisseur du pochoir et ceci quel que soit le diamètre du trou.

Pour les viscosités élevées (dépôt d'adhésifs par exemple), la hauteur déposée est fonction du diamètre et de l'épaisseur du pochoir. Pour les diamètres très petits (200 à 400 micro-mètres), la hauteur déposée est bien moindre que l'épaisseur du pochoir. Le trou sert de réservoir et se recharge à chaque passage de la racle d'une quantité de produit visqueux équivalente à celle qui a été déposée sur le circuit. L'adhérence de la colle sur les flancs du trou entraîne une partie avec le pochoir et n'en laisse qu'une autre partie sur le substrat.

La partie réentraînée par le pochoir est très bien contrôlée et répétitive du fait de la constance de rugosité du trou.
Pour la même épaisseur donnée et pour le même diamètre ou dimension de perçage (800 à 1200 micro-mètres), le réentraînement partiel de la colle très visqueuse, lors de la séparation, provoque la réalisation systématique d'un dôme dont la hauteur peut aller jusqu'à 1,8 fois l'épaisseur du pochoir.
Pour les diamètres supérieurs à 2000 micro-mètres et pour la même épaisseur, les hauteurs déposées sont identiques à l'épaisseur du pochoir. Si l'on veut déposer des hauteurs plus élevées, il faudra choisir un pochoir plus épais et sélectionner le diamètre de perçage approprié en sachant que pour les plus petits diamètres, la hauteur déposée sera identique quelle que soit l'épaisseur de pochoir.

Les propriétés de l'invention permettent de faire cohabiter côte à côte (il n'y a aucune limite de forme) des plots de colle très hauts et des plots de colle très bas. Le rapport de 1 à 20 est possible. Il est possible de coller côte à côte des micro-composants et des gros pavés.

Son avantage considérable sur le pochoir métallique est que, malgré sa tension équivalente, le pochoir réalisé selon la présente invention admet encore de l'élasticité qui permet d'avoir du hors contact lors du dépôt tout en assurant un contact intime avec le substrat. Le pourcentage d'ouverture étant de 100 %, la taille du dépôt possible devient encore plus faible.

Pour les dépôts de crème à braser, il est préférable de déposer des formes circulaires même sur des plages d'accueil de formes variées, comme le carré ou le rectangle. Le cercle sera mieux déposé car c'est la plus grande surface pour le plus petit périmètre, la force d'adhérence étant maximale sur le support pour une force d'entraînement par le pochoir minimale.

Le dépôt des micro-points de colle ou de crème à braser par utilisation du dispositif objet de la présente invention, atteint des diamètres limites d'environ 100 micro-mètres avec une hauteur limite de 50 micro-mètres

D'autres avantages s'ajoutent à ces qualités du pochoir polyester à feuille pleine percée, à savoir :
- le prix de revient est divisé au moins par 3;
- les moyens à mettre en oeuvre pour le fabriquer sont moins onéreux que pour le pochoir métallique;
- le polyester est inaltérable aux acides et solvants;
- la durée de vie est supérieure à celle du pochoir métallique. Le pochoir polyester peut subir à la demande, une déformation plastique permanente pour éviter certaines zones de circuit si besoin.

## Revendications

1. Pochoir (25), (38) pour le dépôt et le dosage de couches plus ou moins épaisses à base de points ou en forme de points d'un produit visqueux sur un substrat, ledit pochoir étant constitué d'une feuille pleine et homogène en un matériau synthétique dotée d'orifices réalisés par des perçages caractérisé en ce que :
- l'épaisseur de la feuille est déterminée en fonction de la plus grande hauteur de dépôt à réaliser sur le substrat,
- et que la feuille présente des diamètres de perçage différents en fonction de la hauteur des différents dépôts à réaliser, les dits diamètres étant également conditionnés par l'épaisseur de la feuille, les dits perçages constituant réservoir chargés à chaque passage d'une racle d'une quantité de produits dont tout ou partie sera déposée sur le substrat de manière régulière par contact étroit entre le pochoir et le substrat à l'endroit où la racle exerce une pression linéaire et en regard de l'ouverture des perçages, ce qui permet de doser les quantités de produit déposées et de contrôler la hauteur des dépôts, les doses de produit déposées et les hauteurs de dépôt obtenues par un passage de la racle étant différentes.

2. Pochoir selon la revendication 1 caractérisé en ce que :
- le plus petit diamètre de perçage du pochoir peut aller jusqu'à être de dimension inférieure à l'épaisseur de la feuille du pochoir.

3. Pochoir selon la revendication 1 caractérisé en ce que chacun des perçages quelle que soit sa dimension a un diamètre constant sur toute l'épaisseur de la feuille.

4. Pochoir selon la revendication 1 et la revendication 3 caractérisé en ce que les orifices de perçage réalisés pour l'un quelconque des différents diamètres sont rigoureusement identiques pour un même diamètre, ce qui permet de réaliser des dépôts rigoureusement semblables.

5. Pochoir selon la revendication 3 caractérisé en ce que les parois des perçages sont relativement lisses ayant une rugosité de surface de l'ordre de 0,001 micron.

6. Pochoir selon la revendication 1 caractérisé en ce que les flancs des perçages sont parallèles entre eux.

7. Procédé pour le dépôt et le dosage de produits visqueux en couches plus ou moins épaisses à base de points ou en forme de points sur un substrat, ledit procédé comprenant l'apposition d'un pochoir plan au-dessus du substrat et l'application du produit visqueux sur le substrat à travers des perçages du pochoir par action d'une racle qui exerce une pression linéaire sur le pochoir plan perpendiculairement au dit pochoir et au substrat, en sens opposé au dit substrat, cette pression linéaire étant suffisante pour déformer le pochoir et pour le mettre en contact avec le substrat au point exact de la pression linéaire, les perçages du pochoir correspondant au dépôt à réaliser sur le substrat caractérisé en ce que le pochoir est constitué d'une feuille pleine extensible homogène réalisée en un matériau synthétique élastique possédant un angle de pliage élevé avec des perçages de transfert dont les flancs sont parallèles entre eux et perpendiculaires au pochoir, la tension étant suffisante pour créer un hors-contact entre le pochoir et le substrat du côté opposé à la racle et en ce que la quantité de produit visqueux déposée à chaque point et la hauteur du point déposé sont déterminées en fonction de l'épaisseur de la feuille du pochoir et du diamètre du perçage de transfert correspondant en sorte que chacun des dépôts issus de perçage ayant le même diamètre et la même rugosité de surface auront la même hauteur.

8. Procédé selon la revendication 7 caractérisé en ce que le pochoir est doté de perçages d'au moins deux diamètres différents pour réaliser des dépôts de différentes hauteurs sur le substrat.

9. Procédé selon les revendications 7 et 8 caractérisé en ce que le produit visqueux est une colle ou une pâte à braser.

10. Procédé selon l'une quelconque des revendications 7, 8, 9 caractérisé en ce que les perçages sont circulaires.

11. Procédé selon l'une quelconque des revendications 7, 8, 9 et 10 caractérisé en ce que la feuille du pochoir est en polyester.

12. Procédé selon l'une quelconque des revendications 7, 8, 9, 10 et 11 caractérisé en ce que les perçages du pochoir sont relativement lisses ayant une rugosité de surface de l'ordre de 0,001 micron.

13. Procédé selon l'une quelconque des revendications 7 à 12 caractérisé en ce que les perçages du pochoir sont réalisés par des forêts.

14. Procédé selon l'une quelconque des revendications 7 à 13 caractérisé en ce que les perçages sont réalisés par laser.

15. Procédé selon l'une quelconque des revendications 7 à 14 caractérisé en ce que l'épaisseur de la feuille du pochoir est choisie en sorte qu'un diamètre de perçage de 200 à 400 micromètres réalise une hauteur de dépôt inférieure à l'épaisseur du pochoir et qu'un diamètre de perçage supérieur à 2000 micromètres réalise une hauteur de dépôt sensiblement égale à l'épaisseur de la feuille du pochoir.

16. Procédé de fabrication d'écrans de sérigraphie à partir d'une feuille pleine et homogène en un matériau synthétique dotée d'orifices réalisés par des perçages caractérisé en ce qu'il consiste à déterminer l'épaisseur de la feuille en fonction de la plus grande hauteur de dépôt à réaliser sur le substrat, à réaliser des perçages de diamètres différents en fonction de la hauteur des différents dépôts à réaliser, les dits diamètres étant également conditionnés par l'épaisseur de la feuille.

17. Procédé selon la revendication 16 caractérisé en ce qu'il consiste à utiliser un outillage mécanique pour réaliser les découpes de la feuille de matière synthétique.

## Claims

1. Stencil (25), (38) for depositing and measuring out layers of differing thicknesses on the basis of dots or in the form of dots of a viscous product on a substrate, said stencil being constituted by a solid, homogeneous sheet of synthetic material provided with holes produced by borings, characterised in that:
- the thickness of the sheet is determined as a function of the greatest height of the deposit to be made on the substrate,
- and that the sheet has different boring diameters as a function of the height of the different deposits to be made, said diameters also being determined by the thickness of the sheet, said borings constituting reservoir filled at each passing over of a scraper with a quantity of product all or part of which will be deposited on the substrate in a regular manner by close contact between the stencil and the substrate at the place where the scraper exerts a linear pressure facing the opening of borings, which makes it possible to measure out the quantities of product deposited and to control the height of the deposits, the measures of the product deposited and the deposit heights obtained by a passing over of the scraper being different.

2. Stencil according to claim 1 characterised in that:
- the smallest boring diameter of the stencil can go as far as being of a dimension less than the thickness of the stencil sheet.

3. Stencil according to claim 1 characterised in that each of the borings, whatever its dimension, has a diameter that is constant over the whole width of the sheet.

4. Stencil according to claim 1 and claim 3 characterised in that the boring holes made for any one of the different diameters are strictly identical for any one diameter, which makes it possible to produce deposits that are strictly alike.

5. Stencil according to claim 3 characterised in that the walls of the borings are relatively smooth, having a surface roughness of the order of 0.001 micron.

6. Stencil according to claim 1 characterised in that the sides of the borings are parallel to each other.

7. Method for the deposition and measuring out of viscous products in layers of differing thicknesses on the basis of dots or in the form of dots on a substrate, said method comprising the placing of a flat stencil over the substrate and the application of the viscous product on the substrate through the borings of the stencil by the action of a scraper, which exerts a linear pressure on the flat stencil perpendicular to said stencil and to the substrate, in the opposite direction to said substrate, this linear pressure being sufficient to deform the stencil and to put it into contact with the substrate at the exact point of the linear pressure, the borings of the stencil corresponding to the deposit to be made on the substrate,characterised in that the stencil is constituted by a solid homogeneous extensible sheet made from an elastic synthetic material having a high folding angle with the transfer borings, the sides of which are parallel to each other and perpendicular to the stencil, the tension being sufficient to create a non-contact area between the stencil and the substrate on the side opposite the scraper and in that the quantity of viscous product deposited at each dot and the height of the dot deposited are determined as a function of the thickness of the stencil sheet and the diameter of the corresponding transfer boring such that each of the deposits coming from the boring having the same diameter and the same surface roughness will have the same height.

8. Method according to claim 7 characterised in that the stencil is given borings of at least two different diameters so as to make deposits of different heights on the substrate.

9. Method according to claims 7 and 8 characterised in that the viscous product is a glue or a brazing paste.

10. Method according to any one of claims 7, 8, 9 characterised in that the borings are circular.

11. Method according to any one of claims 7, 8, 9 and 10 characterised in that the stencil sheet is made of polyester.

12. Method according to any one of claims 7, 8, 9, 10 and 11 characterised in that the borings of the stencil are relatively smooth, having a surface roughness of the order of 0.001 micron.

13. Method according to any one of claims 7 to 12 characterised in that the borings of the stencil are made by drills.

14. Method according to any one of claims 7 to 13 characterised in that the borings are made by laser.

15. Method according to any one of claims 7 to 14 characterised in that the thickness of the stencil sheet is chosen so that a boring diameter of 200 to 400 micrometres makes a deposit height less than the thickness of the stencil and so that a boring diameter of more than 2000 micrometres makes a deposit height substantially equal to the thickness of the stencil sheet.

16. Method of manufacturing silk-screen stencils using a solid homogeneous sheet made of a synthetic material provided with holes made by borings, characterised in that it consists in determining the thickness of the sheet as a function of the greatest deposit height to be made on the substrate, of making borings of different diameters depending on the height of the different deposits to be made, said diameters also being determined by the thickness of the sheet.

17. Method according to claim 16 characterised in that it consists in using mechanical tooling for making the cut-outs of the sheet of synthetic material.

## Patentansprüche

1. Schablone (25), (38) zum Aufbringen und zur Dosierung von mehr oder weniger dicken Schichten, auf der Basis von Punkten oder in Form von Punkten, eines viskosen Produkts auf einem Substrat, wobei die Schablone aus einer soliden und homogenen Folie aus einem Kunststoffmaterial besteht, die mit durch Bohrungen hergestellten Öffnungen versehen ist, dadurch gekennzeichnet, daß:
- die Dicke der Folie in Abhängigkeit von der größten auf dem Substrat herzustellenden Abscheidungshöhe bestimmt ist,
- und daß die Folie in Abhängigkeit von der Höhe der verschiedenen herzustellenden Abscheidungen verschiedene Bohrungsdurchmesser aufweist, die auch durch die Dicke der Folie bedingt sind, wobei die Bohrungen einen Behälter bilden, der bei jedem Durchlauf einer Rakel mit einer Menge von Produkten gefüllt wird, die ganz oder teilweise durch den engen Kontakt zwischen der Schablone und dem Substrat an dem Ort regelmäßig aufgebracht wird, wo die Rakel einen linearen Druck ausübt, sowie gegenüber der Öffnung der Bohrungen, wodurch die aufgebrachten Produktmengen dosiert und die Höhe der Abscheidungen kontrolliert werden kann, wobei die aufgebrachten Produktdosen und die durch einen Durchlauf der Rakel erhaltenen Abscheidungshöhen verschieden sind.

2. Schablone nach Anspruch 1, dadurch gekennzeichnet, daß:
- der kleinste Bohrungsdurchmesser der Schablone bis zu einer kleineren Abmessung als der Dicke der Folie der Schablone gehen kann.

3. Schablone nach Anspruch 1, dadurch gekennzeichnet, daß jede der Bohrungen unabhängig von ihrer Abmessung über die gesamte Dicke der Folie einen konstanten Durchmesser aufweist.

4. Schablone nach Anspruch 1 und Anspruch 3, dadurch gekennzeichnet, daß die Bohrungsöffnungen, die für einen beliebigen der verschiedenen Durchmesser hergestellt sind, für ein und denselben Durchmesser strikt identisch sind, wodurch strikt gleiche Abscheidungen realisiert werden können.

5. Schablone nach Anspruch 3, dadurch gekennzeichnet, daß die Wände der Bohrungen relativ glatt sind und eine Oberflächenrauhigkeit in der Größenordnung von 0,001 Mikron aufweisen.

6. Schablone nach Anspruch 1, dadurch gekennzeichnet, daß die Flanken der Bohrungen zueinander parallel sind.

7. Verfahren zum Aufbringen und zur Dosierung von viskosen Produkten in mehr oder weniger dicken Schichten, auf der Basis von Punkten oder in Form von Punkten, auf einem Substrat, wobei das Verfahren das Anlegen einer ebenen Schablone über dem Substrat und das Aufbringen des viskosen Produkts auf das Substrat durch Öffnungen der Schablone über die Wirkung einer Rakel umfaßt, die einen linearen Druck auf die ebene Schablone senkrecht zu- der Schablone und zu dem Substrat, in Richtung gegen das Substrat, ausübt, wobei dieser lineare Druck ausreicht, um die Schablone zu verformen und genau am Punkt des linearen Drucks mit dem Substrat in Kontakt zu bringen, wobei die Bohrungen der Schablone der auf dem Substrat herzustellenden Abscheidung entsprechen, dadurch gekennzeichnet, daß die Schablone aus einer soliden und homogenen, dehnbaren Folie aus einem elastischen Kunststoffmaterial besteht, das einen hohen Biegewinkel mit Übertragungsbohrungen besitzt, deren Flanken zueinander parallel und senkrecht zur Schablone sind, wobei die Spannung ausreicht, um einen Freiraum zwischen der Schablone und dem Substrat an der der Rakel entgegengesetzten Seite zu schaffen, und daß die Menge an viskosem Produkt, die an jedem Punkt aufgebracht wird, sowie die Höhe des aufgebrachten Punkts in Abhängigkeit von der Dicke der Folie der Schablone und dem Durchmesser der entsprechenden Übertragungsbohrung bestimmt sind, so daß jede aus einer Bohrung abgegebene Abscheidung mit dem gleichen Durchmesser und der gleichen Oberflächenrauhigkeit die gleiche Höhe besitzt.

8. Verfahren nach Anspruch 7, dadurch gekennzeichnet, daß die Schablone mit Bohrungen mit wenigstens zwei verschiedenen Durchmessern versehen ist, um auf dem Substrat Abscheidungen mit verschiedenen Höhen herzustellen.

9. Verfahren nach den Ansprüchen 7 und 8, dadurch gekennzeichnet, daß das viskose Produkt ein Kleber oder eine Lötpaste ist.

10. Verfahren nach einem der Ansprüche 7, 8, 9, dadurch gekennzeichnet, daß die Bohrungen kreisförmig sind.

11. Verfahren nach einem der Ansprüche 7, 8, 9 und 10, dadurch gekennzeichnet, daß die Folie der Schablone aus Polyester besteht.

12. Verfahren nach einem der Ansprüche 7, 8, 9, 10 und 11, dadurch gekennzeichnet, daß die Bohrungen der Schablone bei einer Oberflächenrauhigkeit in der Größenordnung von 0,001 Mikron relativ glatt sind.

13. Verfahren nach einem der Ansprüche 7 bis 12, dadurch gekennzeichnet, daß die Bohrungen der Schablone durch Bohrer hergestellt sind.

14. Verfahren nach einem der Ansprüche 7 bis 13, dadurch gekennzeichnet, daß die Bohrungen durch Laser hergestellt sind.

15. Verfahren nach einem der Ansprüche 7 bis 14, dadurch gekennzeichnet, daß die Dicke der Folie der Schablone derart gewählt ist, daß ein Bohrungsdurchmesser von 200 bis 400 Mikrometern eine Abscheidungshöhe unter der Dicke der Schablone herstellt, und daß ein Bohrungsdurchmeser über 2000 Mikrometer eine Abscheidungshöhe herstellt, die im wesentlichen gleich der Dicke der Folie der Schablone ist.

16. Verfahren zur Herstellung von Siebdruckschablonen aus einer soliden und homogenen Folie aus einem Kunststoffmaterial, die mit durch Bohrungen hergestellten Öffnungen versehen ist, dadurch gekennzeichnet, daß es darin besteht, die Dicke der Folie in Abhängigkeit von der größten, auf dem Substrat herzustellenden Abscheidungshöhe zu bestimmen und Bohrungen mit verschiedenen Durchmessern in Abhängigkeit von der Höhe der verschiedenen, herzustellenden Abscheidungen zu realisieren, wobei die Durchmesser ebenfalls durch die Dicke der Folie bedingt sind.

17. Verfahren nach Anspruch 16, dadurch gekennzeichnet, daß es darin besteht, ein mechanisches Werkzeug zur Herstellung der Ausschnitte in der Folie aus Kunststoffmaterial zu verwenden.
